# EUROPEAN PATENT SPECIFICATION

(11) **EP 2 648 214 B1**
(45) Date of publication and mention of the grant of the patent: **12.06.2019**
(21) Application number: 12163391.1
(22) Date of filing: 05.04.2012
(51) Int. Cl.: H01L 21/768, H01L 23/48

(54) **Methods of producing a semiconductor device with a through-substrate via**
Herstellungsverfahren für ein Halbleiterbauelement mit Substratdurchkontaktierung
Procédés de production d'un dispositif semi-conducteur avec interconnexion traversant le substrat

(43) Date of publication of application: 09.10.2013
(73) Proprietor: ams AG, 8141 Premstätten (AT)
(72) Inventor: Löffler, Bernhard, 8200 Gleisdorf (AT); Rohracher, Karl, 8041 Graz (AT); Schrank, Franz, 8052 Graz (AT); Siegert, Jörg, 8020 Graz (AT); Kraft, Jochen, 8600 Bruck an der Mur (AT)
(74) Representative: Epping - Hermann - Fischer

(56) References cited:
- WO-A1-2009/115449
- US-A1- 2004 229 398
- US-A1- 2006 033 168
- US-A1- 2009 134 497
- US-A1- 2012 007 243

## Description

DE 10 2009 004 725 A1 describes stacked semiconductor devices with a bond layer including a buried contact pad, which is connected with a metal layer on the upper surface of one of the wafers by means of a metallization in a through-wafer via. The contact pad and the surface metal layer can be connected with a metal plane of a wiring or with a contact pad that is provided for a connection with a further semiconductor device.

US 2011/0215458 A1 describes a semiconductor device and a method of forming a package-on-package structure. The electrical interconnection between a wafer level chip scale package containing semiconductor devices in threedimensional integration and external devices is accomplished with conductive through-silicon vias. Conductive layers are formed on both sides of a semiconductor device. Through-silicon vias are subsequently formed and filled with electrically conductive material.

US 2010/0308443 A1 describes a semiconductor device and a method of forming an interconnect structure with through-silicon vias using an encapsulant for structural support.

US 2012/0007243 A1 discloses a method of making electrical connections in a semiconductor device comprising a semiconductor substrate, an insulating region, a dielectric layer and a doped polysilicon layer. An opening is etched through the substrate, and etching stops on the doped polysilicon. The opening is filled with aluminum, which contacts a metal track of an interconnect level via the doped polysilicon and conductive vias.

US 2006/0033168 A1 discloses a manufacturing method of a semiconductor device, in which an insulating layer is applied, an opening or recess is formed in the insulating layer, and a pad electrode is formed in the opening or recess by sputtering an aluminum layer.

WO 2009/115449 A1 discloses a method for fabricating through-substrate vias. A pre-metal dielectric and first contact plugs are applied to the front-side of a substrate, where active devices are located. Second contact plugs are arranged at a location provided for a through-substrate via. Via holes having a diameter between 500 nm and 500 µm are etched from the backside to an etch stop layer. The via holes can be filled with a conductive material for good electrical contact between the through-substrate via and the contact plugs.

US 2009/0134497 A1 discloses a through-substrate via comprising a trench metal liner and a fill material. The through-substrate via extends up to first vias of a landing pad, which may include substrate contact vias.

US 2004/0229398 A1 discloses ball limiting metallurgy pads, which are applied on exposed surfaces of metal capture vias and are provided for a ball grid array. Through-substrate vias are confined to a carrier body.

WO 2011/093955 A2 describes a method of forming stacks of semiconductor devices using through-substrate vias in a wafer, which is mounted to a carrier wafer and thinned from a bottom side. Embedded metal tips are thus exposed, which are then mounted on a printed circuit board.

It is an object of the invention to provide a way of easily connecting an interconnection via through a semiconductor substrate to the wiring of an integrated circuit.

This object is achieved with the method of producing a semiconductor device according to claim 1 or 4. Variants and refinements derive from the dependent claims.

The semiconductor device comprises a substrate of semiconductor material with a main surface and an opposite surface, an integrated circuit component in the substrate at or near the main surface, a structured metal plane at a distance from the substrate above the main surface, a dielectric layer between the metal plane and the substrate, an electrical interconnect between the metal plane and the integrated circuit component, the interconnect traversing the dielectric layer, and an interconnection via comprising a metallization leading through the substrate between the main surface and the opposite surface. The metallization is connected to the metal plane via a further electrical interconnect traversing the dielectric layer.

The further electrical interconnect can be formed by a contact plug.

The further electrical interconnect can be formed by a plurality of contact plugs.

The further electrical interconnect and the electrical interconnect between the metal plane and the integrated circuit component can be formed by similar contact plugs.

The further electrical interconnect can be formed by a deepening or indentation of the metal plane towards the metallization.

A structured further metal plane can be arranged at the opposite surface of the substrate, and the metallization of the interconnection via can be electrically connected to the further metal plane.

In a method of producing the semiconductor device an integrated circuit component is formed at or near a main surface of a semiconductor substrate, a dielectric layer is applied on the main surface, an electrical interconnect is formed traversing the dielectric layer, a structured metal plane is formed on the dielectric layer, so that the interconnect contacts the metal plane, and an interconnection via is formed with a metallization leading through the substrate between the main surface and the opposite surface. A further electrical interconnect traversing the dielectric layer is formed in an area that is provided for the interconnection via. The metal plane is formed in contact with the further electrical interconnect. The metallization is connected to the further electrical interconnect. The further electrical interconnect is arranged at a distance of less than 0.1 µm from the semiconductor material of the substrate before the interconnection via is etched from the opposite surface.

In a configuration of the method the electrical interconnect and the further electrical interconnect are formed by contact plugs.

An insulating region of dielectric material is formed in an area that is provided for the interconnection via, a stop layer is applied on the insulation region, the further electrical interconnect is arranged on the stop layer, the substrate is etched from its opposite surface to open the interconnection via, and the insulating region and the stop layer are at least partially removed before the metallization of the interconnection via is applied on the further electrical interconnect.

In a further method a recess is formed in the dielectric layer in an area that is provided for the interconnection via, and the metal plane is applied with a deepening or indentation extending into the recess, thus forming the further electrical interconnect.

In a further configuration of the method a layer of dielectric material is applied in the interconnection via before the metallization is applied. The dielectric material is anisotropically etched until a contact area that is provided for an electrical connection of the metallization with the further electrical interconnect is uncovered and a sidewall spacer is formed. The metallization is applied so that the spacer insulates the metallization from the semiconductor material of the substrate.

The following is a detailed description of examples of the invention and its advantages in conjunction with the accompanying drawings.
Figure 1 shows a cross section of a semiconductor device.
Figure 2 shows a cross section according to Figure 1 of the interconnection via before the etching of sidewall spacers.
Figure 3 shows a cross section according to Figure 1 of a further semiconductor device.
Figure 4 shows a cross section according to Figure 3 of the interconnection via before the etching of sidewall spacers.
Figure 5 shows a cross section according to Figure 3 with an electrically conductive stop layer.
Figure 6 shows a cross section according to Figure 5 of the interconnection via before the application of the metallization.
Figure 7 shows a cross section according to Figure 1 of a further semiconductor device.
Figure 8 shows a cross section according to Figure 7 of the interconnection via showing additional details.

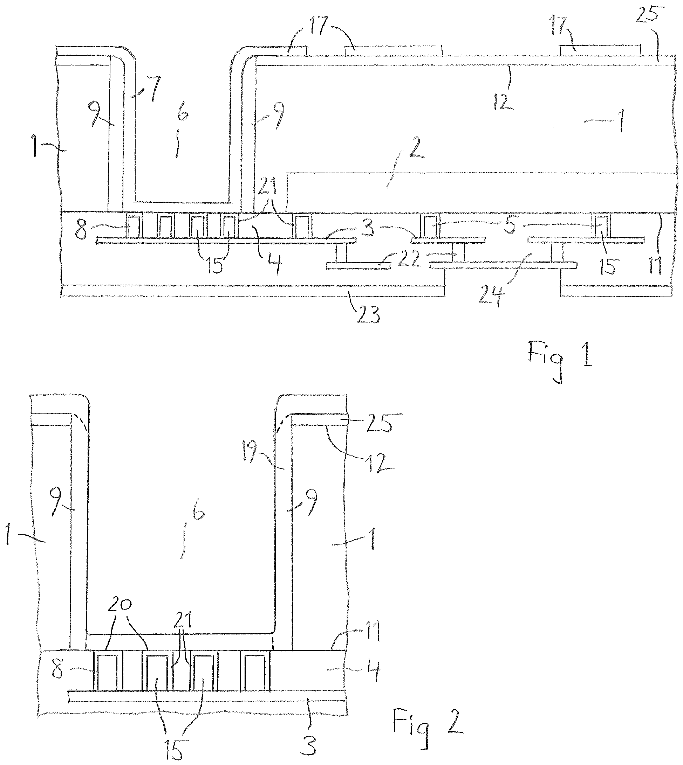

Figure 1 shows a cross section of a
semiconductor device comprising a substrate 1 of semiconductor material, which may be silicon, for example, with a main surface 11 and an opposite surface 12. At least one integrated circuit component 2, which may be part of a CMOS circuitry, for example, is arranged in the substrate 1 at or near the main surface 11. A structured metal plane 3 is arranged at a distance from the substrate 1. A dielectric layer 4 is arranged between the substrate 1 and the metal plane 3. The metal plane 3 may be provided for an electrical connection of terminals of the integrated circuit component 2 by means of an electrical interconnect 5, which traverses the dielectric layer 4 between the metal plane 3 and the integrated circuit component 2. The electrical interconnect 5 may comprise several separate conductor vias and may be formed by contact plugs 15, for example, which may be tungsten.

The metal plane 3 may form part of a wiring 22 comprising metal layers and vias embedded in an intermetal dielectric 24. The metal plane 3 may especially be a first metal level of the wiring 22. An exterior surface may be covered by a passivation 23. A further dielectric layer 25 may be arranged above the opposite surface 12 of the substrate 1 and may comprise a further structured metal layer or wiring used as a redistribution layer or the like.

An interconnection via 6 is provided in the substrate 1 according to a through-wafer via, through-silicon via or plated through-hole to connect the metal plane 3 with an electrical conductor at or above the opposite surface 12. The interconnection via 6 comprises a metallization 7, which is preferably insulated from the semiconductor material of the substrate 1 by a sidewall spacer 9 of dielectric material, especially an oxide of the semiconductor material. The metallization 7 may be connected with a structured further metal plane 17 at or above the opposite surface 12 of the substrate 1.

A further electrical interconnect 8 traversing the dielectric layer 4 connects the metal plane 3 and the metallization 7. The further electrical interconnect 8 bridges the gap between the metal plane 3 and the metallization 7 and thus obviates the need to open the dielectric layer 4 locally to enable a direct connection of the metallization 7 and the metal plane 3. In the device according to Figure 1 the further electrical interconnect 8 is formed by contact plugs 15, which may be tungsten, for example. The contact plugs 15 may be formed with a liner 21 arranged between the contact plugs 15 and the metallization 7.

Figure 2 shows a cross section of the region of the interconnection via 6 and the further electrical interconnect 8 for an intermediate product of a method of producing the device according to Figure 1. A layer of dielectric material 19, which may be an oxide of the semiconductor material, especially silicon oxide, is applied to the bottom and sidewall of the interconnection via 6. The dielectric material is anisotropically etched to remove the horizontal portions of the layer of dielectric material 19 while leaving the vertical portions in the shape of the spacer 9 as indicated by the broken lines. This partial removal of the dielectric material may be effected by deep reactive ion etching (DRIE).

Figure 2 clearly shows that only a comparatively thin dielectric layer has to be removed from the bottom of the interconnection via 6 in order to uncover the contact area 20 of the further electrical interconnect 8. The contact area 20 can be formed by the liner 21 or directly by bottom areas of the contact plugs 15. If it were necessary to etch through the dielectric layer 4, which is typically about 1 µm thick, the etching process would last considerably longer and the requirements of subsequent cleaning steps to remove undesired etch residues would be increased. The further electrical interconnect 8 therefore facilitates the application of the metallization 7 substantially.

In the device according to Figure 2 the contact plugs 15 reach the plane of the main surface 11 and traverse the whole thickness of the dielectric layer 4. The further electrical interconnect 8 may instead be shallower than the dielectric layer 4. In this case a thin layer portion of the dielectric layer 4 that remains between the further electrical interconnect 8 and the semiconductor material of the substrate 1 is removed when the spacer 9 is etched.

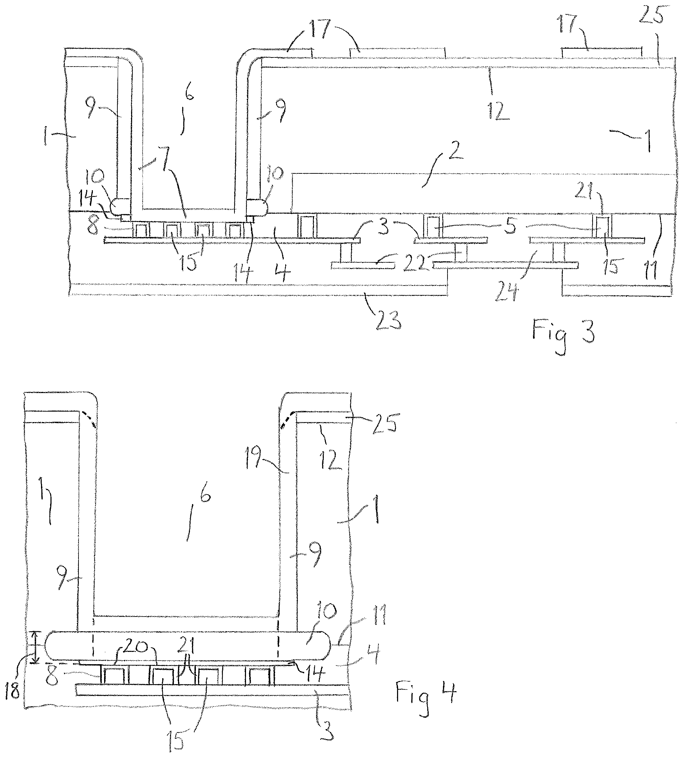

Figure 3 shows a cross section according to Figure 1 for a semiconductor device that is produced according to the invention. The elements corresponding to elements of the device according to Figure 1 are designated with the same reference numerals. The device according to Figure 3 uses a stop layer 14, which is present when the further electrical interconnect 8 is formed. The stop layer 14 is removed from the contact area 20 before the metallization 7 is applied to the further electrical interconnect 8. Figure 3 shows a lateral remnant of the stop layer 14, which has been removed from the area that is occupied by the bottom of the interconnection via 6. The stop layer 14 is applied to an insulating region 10 formed at the main surface 11. The insulating region 10 may be an oxide of the semiconductor material, for instance. The interconnection via 6 is etched through the insulating region 10, lateral remnants of which are also shown in Figure 3.

Figure 4 shows a cross section of the region of the interconnection via 6 and the further electrical interconnect 8 for an intermediate product of a method of producing the device according to Figure 3. An insulating region 10, which may be a field oxide or a shallow trench isolation, is formed at the main surface 11 of the substrate 1 in the area that is provided for the interconnection via 6. A stop layer 14 is applied on the insulating region 10. The stop layer 14 may be any suitable material used in the process, like polysilicon, especially electrically conductively doped polysilicon provided for gate electrodes, a metal silicide, an oxide layer, especially a buried oxide of a silicon-on-insulator structure, for example, or an electrically conductive material that is used for resistors or capacitor plates of further components supplementing the integrated circuitry.

Figure 4 shows how the further electrical interconnect 8 is arranged on the stop layer 14, which may be provided to stop the formation of the further electrical interconnect 8 at a precise limit above the insulating region 10. This may be especially favourable if the further electrical interconnect 8 is produced by filling via holes with a metal like tungsten to form contact plugs 15. The distance 18 between the further electrical interconnect 8 and the semiconductor material of the substrate 1 is defined by the sum of the thickness of the insulating region 10, which is typically about 0.04 µm, for example, and the thickness of the stop layer 14.
This distance 18 is less than 0.1 µm, preferably
less than 0.05 µm.

The interconnection via 6 is opened from the opposite side 12 of the substrate 1. A layer of dielectric material 19 is provided for the sidewall spacer 9. When the spacer 9 is etched, the insulating region 10 is also etched until the stop layer 14 is reached. The stop layer 14 is preferably a material that functions as an etch stop, so that the spacer etching stops - or at least the etch rate is essentially decreased - when the stop layer 14 is reached. The stop layer 14 may be removed to uncover a contact area 20 formed by the liner 21 or bottom areas of the contact plugs 15. Then the metallization 7 is applied.

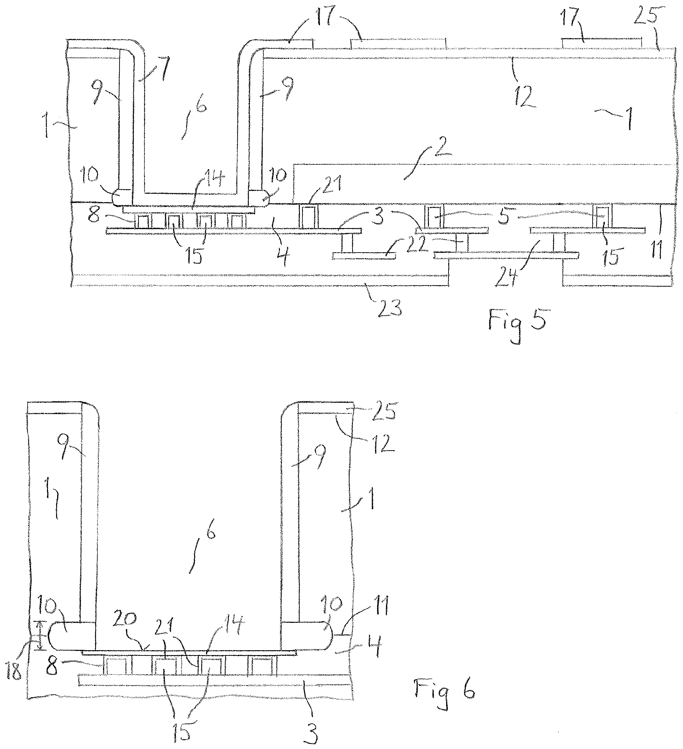

Figure 5 shows a cross section according to Figure 3 for a further semiconductor device, in which the
stop layer 14 is formed from electrically conductive material and is left as a part of the further electrical interconnect 8 between the metallization 7 of the interconnection via 6 and the contact plugs 15. The electrically conductive stop layer 14 may particularly be polysilicon, which is electrically conductively doped and may be provided in the process for the formation of gate electrodes. Instead, the stop layer 14 may be a metal silicide, especially tungsten silicide, or any other electrically conductive material that is available in the process. The electrical conductivity and the small thickness of the stop layer 14 are preferably adapted to render the resistance between the metallization 7 and the contact plugs 15 sufficiently small.

Figure 6 shows a cross section according to Figure 4 for a further intermediate product. Figure 6 shows the structure of the interconnection via 6 after the etching of the spacer 9 and the removal of the dielectric material of the insulating region 10 from the bottom of the interconnection via 6, where the stop layer 14 is uncovered. If the stop layer 14 is electrically conductive, the metallization 7 can be applied directly to the free surface of the stop layer 14, which is used as the contact area 20 of the further electrical interconnect 8. In this case the distance 18 between the further electrical interconnect 8 and the semiconductor material of the substrate 1 is the thickness of the insulating region 10, which is less than 0.1 µm, preferably less than 0.05 µm, and typically about 0.04 µm, for example. The result is the device structure shown in Figure 5. Instead, the stop layer 14 may be removed from the bottom of the interconnection via 6, preferably by an etching step that is selective with respect to the liner 21 and/or the contact plugs 15 and to the dielectric layer 4, as described above in conjunction with the device according to Figure 3.

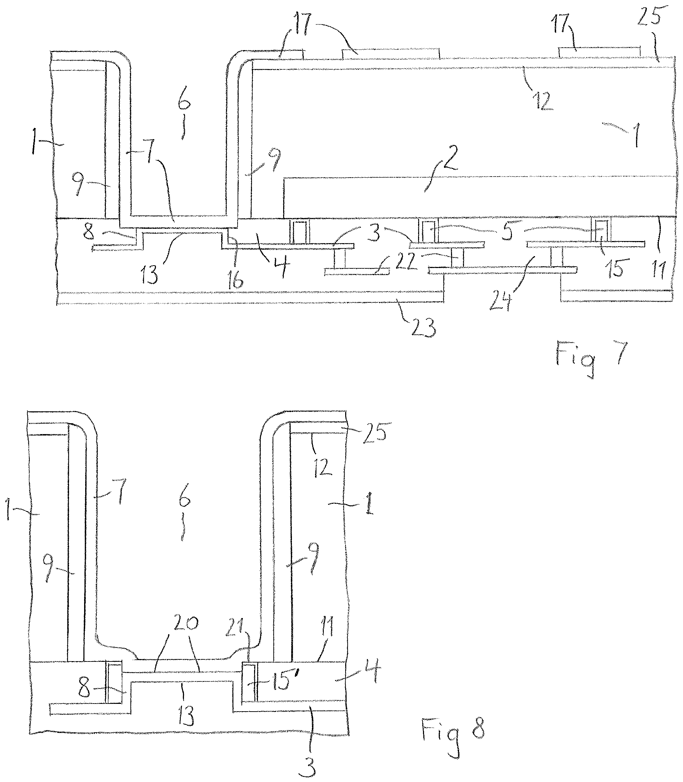

Figure 7 shows a cross section according to Figure 1 for a further semiconductor device. The elements corresponding to elements of the device according to Figure 1 are designated with the same reference numerals. Before the metal plane 3 of the device according to Figure 7 is produced, a recess 16 is formed in the dielectric layer 4, which causes the metal plane 3 to form a deepening or indentation 13 within the recess 16. The deepening or indentation 13 of the metal plane 3 is provided as the further electrical interconnect 8 and is connected with the metallization 7 of the interconnection via 6. The recess 16 may completely open the dielectric layer 4, or it may only reduce the remaining thickness of the dielectric layer 4 in the area provided for the interconnection via 6.

Figure 8 shows a cross section of the region of the interconnection via 6 and the further electrical interconnect 8 for an intermediate product of a method of producing the device according to Figure 7. The liner 21 and the material that is provided for the contact plugs 15 may also be used to form an interconnect spacer 15' laterally limiting the recess 16. In the device shown in Figure 8 the recess 16 does not traverse the dielectric layer 4, and the further electrical interconnect 8 does therefore not reach up to the plane of the main surface 11. The metallization 7 is consequently applied in the stepped shape shown in Figure 8.

The described method of production has the advantage that any wafer processed in a standard CMOS process can be used as start material. No substantial modification of the process is necessary, because the described method only makes use of steps that are already implemented in the process. A short spacer etching time, which is desired to decrease the manufacturing costs, is also favourable to secure a complete coverage of the upper portion of the semiconductor sidewall in the interconnection via and to obviate problems concerning subsequent cleaning procedures. Furthermore it is advantageous that it is not necessary to fill the interconnection via. The production of a through-wafer via in a substrate that is provided with an integrated circuit is substantially facilitated by the described method and device structure.

### List of reference numerals

- 1: substrate
- 2: integrated circuit component
- 3: metal plane
- 4: dielectric layer
- 5: electrical interconnect
- 6: interconnection via
- 7: metallization
- 8: further electrical interconnect
- 9: spacer
- 10: insulating region
- 11: main surface
- 12: opposite surface
- 13: deepening or indentation
- 14: stop layer
- 15: contact plug
- 15': interconnect spacer
- 16: recess
- 17: further metal plane
- 18: distance
- 19: layer of dielectric material
- 20: contact area
- 21: liner
- 22: wiring
- 23: passivation
- 24: intermetal dielectric
- 25: further dielectric layer

## Claims

1. A method of producing a semiconductor device, comprising:
- forming an integrated circuit component (2) at or near a main surface (11) of a semiconductor substrate (1),
- forming an insulating region (10) at the main surface (11) in an area that is provided for an interconnection via (6),
- applying a stop layer (14) on the insulating region (10),
- applying a dielectric layer (4) on the main surface (11),
- forming an electrical interconnect (5) traversing the dielectric layer (4) and a further electrical interconnect (8) traversing the dielectric layer (4) in the area that is provided for the interconnection via (6), the further electrical interconnect (8) being arranged on the stop layer (14) at a distance (18) from the semiconductor material of the substrate (1) before the interconnection via (6) is etched,
- arranging a structured metal plane (3) on the dielectric layer (4), the interconnect (5) and the further electrical interconnect (8) contacting the metal plane (3), the interconnect (5) traversing the dielectric layer (4) between the metal plane (3) and the integrated circuit component (2),
- etching the substrate (1) from an opposite surface (12) to open the interconnection via (6) and at least partially removing the insulating region (10), and
- providing the interconnection via (6) with a metallization (7) leading through the substrate (1) between the main surface (11) and the opposite surface (12), the metallization (7) being connected to the further electrical interconnect (8),
**characterized in that**
- the further electrical interconnect (8) traversing the dielectric layer (4) is arranged at a distance (18) of less than 0.1 µm from the semiconductor material of the substrate (1) before the interconnection via (6) is etched, and
- the stop layer (14) is removed to uncover a contact area (20) of the further electrical interconnect (8) before the metallization (7) is connected to the further electrical interconnect (8).

2. The method of claim 1, wherein the electrical interconnect (5) and the further electrical interconnect (8) are formed by contact plugs (15).

3. The method of one of claims 1 or 2, further comprising:
applying a layer of dielectric material (19) in the interconnection via (6) before the metallization (7) is applied,
anisotropically etching the dielectric material until a contact area (20) that is provided for an electrical connection of the metallization (7) with the further electrical interconnect (8) is uncovered and a sidewall spacer (9) is formed, and
applying the metallization (7), the spacer (9) insulating the metallization (7) from the semiconductor material of the substrate (1).

4. A method of producing a semiconductor device, comprising:
- forming an integrated circuit component (2) at or near a main surface (11) of a semiconductor substrate (1),
- applying a dielectric layer (4) on the main surface (11),
- forming an electrical interconnect (5) traversing the dielectric layer (4),
- forming a recess (16) in the dielectric layer (4) in an area that is provided for an interconnection via (6),
- forming a structured metal plane (3) on the dielectric layer (4), so that the interconnect (5) contacts the metal plane (3), the metal plane (3) being applied with a deepening or indentation (13) extending into the recess (16), thus forming a further electrical interconnect (8),
- etching the interconnection via (6) from an opposite surface (12) through the substrate (1), and
- providing the interconnection via (6) with a metallization (7) leading through the substrate (1) between the main surface (11) and the opposite surface (12), the metallization (7) being connected to the metal plane (3) on the deepening or indentation (13),
**characterized in that**
- the electrical interconnect (5) traversing the dielectric layer (4) comprises a contact plug (15),
- a material that is provided for the contact plug (15) is also used to form an interconnect spacer (15') laterally limiting the recess (16).

5. The method of claim 4, further comprising:
applying a layer of dielectric material (19) in the interconnection via (6) before the metallization (7) is applied,
anisotropically etching the dielectric material until a contact area (20) that is provided for an electrical connection of the metallization (7) with the metal plane (3) is uncovered and a sidewall spacer (9) is formed, and
applying the metallization (7), the spacer (9) insulating the metallization (7) from the semiconductor material of the substrate (1).

## Patentansprüche

1. Verfahren zum Herstellen eines Halbleiterbauteils, umfassend:
- Ausbilden einer integrierten Schaltungskomponente (2) an oder nahe an einer Hauptfläche (11) eines Halbleitersubstrats (1),
- Ausbilden eines Isolierbereichs (10) an der Hauptfläche (11) in einem Bereich, der für einen Zwischenverbindungsdurchgang (6) vorgesehen ist,
- Aufbringen einer Stoppschicht (14) auf den Isolierbereich (10),
- Aufbringen einer dielektrischen Schicht (4) auf die Hauptfläche (11),
- Ausbilden einer die dielektrische Schicht (4) durchquerenden elektrischen Zwischenverbindung (5) und einer die dielektrische Schicht (4) durchquerenden weiteren elektrischen Zwischenverbindung (8) in dem Bereich, der für den Zwischenverbindungsdurchgang (6) vorgesehen ist, wobei die weitere elektrische Zwischenverbindung (8) auf der Stoppschicht (14) in einem Abstand (18) von dem Halbleitermaterial des Substrats (1) angeordnet wird, bevor der Zwischenverbindungsdurchgang (6) geätzt wird,
- Anordnen einer strukturierten Metallebene (3) auf der dielektrischen Schicht (4), wobei die Zwischenverbindung (5) und die weitere elektrische Zwischenverbindung (8) die Metallebene (3) kontaktieren, wobei die Zwischenverbindung (5) die dielektrische Schicht (4) zwischen der Metallebene (3) und der integrierten Schaltungskomponente (2) durchquert,
- Ätzen des Substrats (1) ausgehend von einer entgegengesetzten Fläche (12), um den Zwischenverbindungsdurchgang (6) zu öffnen und zumindest teilweise den Isolierbereich (10) zu entfernen, und
- Versehen des Zwischenverbindungsdurchgangs (6) mit einer Metallisierung (7), die zwischen der Hauptfläche (11) und der entgegengesetzten Fläche (12) durch das Substrat (1) führt, wobei die Metallisierung (7) an die weitere elektrische Zwischenverbindung (8) angeschlossen wird,
**dadurch gekennzeichnet, dass**
- die weitere elektrische Zwischenverbindung (8), welche die dielektrische Schicht (4) durchquert, in einem Abstand (18) von weniger als 0,1 µm vom Halbleitermaterial des Substrats (1) angeordnet wird, bevor der Zwischenverbindungsdurchgang (6) geätzt wird, und
- die Stoppschicht (14) entfernt wird, um eine Kontaktfläche (20) der weiteren elektrischen Zwischenverbindung (8) aufzudecken, bevor die Metallisierung (7) an die weitere elektrische Zwischenverbindung (8) angeschlossen wird.

2. Verfahren nach Anspruch 1, wobei die elektrische Zwischenverbindung (5) und die weitere elektrische Zwischenverbindung (8) durch Kontaktstopfen (15) gebildet werden.

3. Verfahren nach einem der Ansprüche 1 oder 2, darüber hinaus umfassend:
Aufbringen einer Schicht dielektrischen Materials (19) in dem Zwischenverbindungsdurchgang (6), bevor die Metallisierung (7) aufgebracht wird,
anisotropes Ätzen des dielektrischen Materials, bis eine Kontaktfläche (20), die für eine elektrische Verbindung der Metallisierung (7) mit der weiteren elektrischen Zwischenverbindung (8) vorgesehen ist, aufgedeckt und ein Seitenwandabstandhalter (9) gebildet ist, und
Aufbringen der Metallisierung (7), wobei der Abstandhalter (9) die Metallisierung (7) von dem Halbleitermaterial des Substrats (1) isoliert.

4. Verfahren zum Herstellen eines Halbleiterbauteils, umfassend:
- Ausbilden einer integrierten Schaltungskomponente (2) an oder nahe an einer Hauptfläche (11) eines Halbleitersubstrats (1),
- Aufbringen einer dielektrischen Schicht (4) auf die Hauptfläche (11),
- Ausbilden einer die dielektrische Schicht (4) durchquerenden elektrischen Zwischenverbindung (5),
- Ausbilden einer Ausnehmung (16) in der dielektrischen Schicht (4) in einem Bereich, der für einen Zwischenverbindungsdurchgang (6) vorgesehen ist,
- Ausbilden einer strukturierten Metallebene (3) auf der dielektrischen Schicht (4), so dass die Zwischenverbindung (5) die Metallebene (3) kontaktiert, wobei die Metallebene (3) mit einer Vertiefung oder Einrückung (13) aufgebracht wird, die sich in die Ausnehmung (16) erstreckt, wodurch eine weitere elektrische Zwischenverbindung (8) gebildet wird,
- Ätzen des Zwischenverbindungsdurchgangs (6) ausgehend von einer entgegengesetzten Fläche (12) durch das Substrat (1) hindurch, und
- Versehen des Zwischenverbindungsdurchgangs (6) mit einer Metallisierung (7), die zwischen der Hauptfläche (11) und der entgegengesetzten Fläche (12) durch das Substrat (1) führt, wobei die Metallisierung (7) auf der Vertiefung oder Einrückung (13) an die Metallebene (3) angeschlossen wird,
**dadurch gekennzeichnet, dass**
- die elektrische Zwischenverbindung (5), welche die dielekrische Schicht (4) durchquert, einen Kontaktstopfen (15) aufweist,
- ein Material, das für den Kontaktstopfen (15) vorgesehen ist, auch dazu verwendet wird, einen Zwischenverbindungsabstandhalter (15') auszubilden, der die Ausnehmung (16) seitlich begrenzt.

5. Verfahren nach Anspruch 4, darüber hinaus umfassend:
Aufbringen einer Schicht dielektrischen Materials (19) in dem Zwischenverbindungsdurchgang (6), bevor die Metallisierung (7) aufgebracht wird,
anisotropes Ätzen des dielektrischen Materials, bis eine Kontaktfläche (20), die für eine elektrische Verbindung der Metallisierung (7) mit der Metallebene (3) vorgesehen ist, aufgedeckt und ein Seitenwandabstandhalter (9) gebildet ist, und
Aufbringen der Metallisierung (7), wobei der Abstandhalter (9) die Metallisierung (7) von dem Halbleitermaterial des Substrats (1) isoliert.

## Revendications

1. Procédé de production d'un dispositif semiconducteur, comprenant:
- la formation d'un composant de circuit intégré (2) sur ou près d'une surface principale (11) d'un substrat semiconducteur (1),
- la formation d'une région isolante (10) sur la surface principale (11) dans une aire qui est prévue pour une traversée d'interconnexion (6),
- l'application d'une couche d'arrêt (14) sur la région isolante (10),
- l'application d'une couche diélectrique (4) sur la surface principale (11),
- la formation d'une interconnexion électrique (5) traversant la couche diélectrique (4) et d'une interconnexion électrique supplémentaire (8) traversant la couche diélectrique dans l'aire qui est prévue pour la traversée d'interconnexion (6), l'interconnexion électrique supplémentaire (8) étant agencée sur la couche d'arrêt (14) à une distance (18) du matériau semiconducteur du substrat (1) avant que la traversée d'interconnexion (6) soit gravée,
- l'agencement d'un plan de métal structuré (3) sur la couche diélectrique (4), l'interconnexion (5) et l'interconnexion électrique supplémentaire (8) étant en contact avec le plan de métal (3), l'interconnexion (5) traversant la couche diélectrique (4) entre le plan de métal (3) et le composant de circuit intégré (2),
- la gravure du substrat (1) depuis une surface opposée (12) pour ouvrir la traversée d'interconnexion (6) et l'enlèvement au moins partiel de la région isolante (10), et
- le fait de doter la traversée d'interconnexion (6) d'une métallisation (7) menant à travers le substrat (1) entre la surface principale (11) et la surface opposée (12), la métallisation (7) étant connectée à l'interconnexion électrique supplémentaire (8),
**caractérisé en ce que**
- l'interconnexion électrique supplémentaire (8) traversant la couche diélectrique (4) est agencée à une distance (18) de moins de 0,1 µm du matériau semiconducteur du substrat (1) avant que la traversée d'interconnexion (6) soit gravée, et
- la couche d'arrêt (14) est enlevée pour découvrir une aire de contact (20) de l'interconnexion électrique supplémentaire (8) avant que la métallisation (7) soit connectée à l'interconnexion électrique supplémentaire (8) .

2. Le procédé de la revendication 1, sachant que l'interconnexion électrique (5) et l'interconnexion électrique supplémentaire (8) sont formées par des fiches de contact (15).

3. Le procédé de l'une des revendications 1 ou 2, comprenant en outre:
l'application d'une couche de matériau diélectrique (19) dans la traversée d'interconnexion (6) avant que la métallisation (7) soit appliquée,
la gravure anisotrope du matériau diélectrique jusqu'à ce qu'une aire de contact (20) qui est prévue pour une connexion électrique de la métallisation (7) avec l'interconnexion électrique supplémentaire (8) soit découverte et une entretoise de paroi latérale (9) soit formée, et
l'application de la métallisation (7), l'entretoise (9) isolant la métallisation (7) du matériau semiconducteur du substrat (1).

4. Procédé de production d'un dispositif semiconducteur, comprenant:
- la formation d'un composant de circuit intégré (2) sur ou près d'une surface principale (11) d'un substrat semiconducteur (1),
- l'application d'une couche diélectrique (4) sur la surface principale (11),
- la formation d'une interconnexion électrique (5) traversant la couche diélectrique (4),
- la formation d'un évidement (16) dans la couche diélectrique (4) dans une aire qui est prévue pour une traversée d'interconnexion (6),
- la formation d'un plan de métal structuré (3) sur la couche diélectrique (4) de telle sorte que l'interconnexion (5) soit en contact avec le plan de métal (3), le plan de métal (3) étant appliqué avec un renfoncement ou une indentation (13) s'étendant dans l'évidement (16), formant ainsi une interconnexion électrique supplémentaire (8),
- la gravure de la traversée d'interconnexion (6) depuis une surface opposée (12) à travers le substrat (1), et
- le fait de doter la traversée d'interconnexion (6) d'une métallisation (7) menant à travers le substrat (1) entre la surface principale (11) et la surface opposée (12), la métallisation (7) étant connectée au plan de métal (3) sur le renfoncement ou l'indentation (13),
**caractérisé en ce que**
- l'interconnexion électrique (5) traversant la couche diélectrique (4) comprend une fiche de contact (15),
- un matériau qui est prévu pour la fiche de contact (15) est également utilisé pour former une entretoise d'interconnexion (15') limitant latéralement l'évidement (16) .

5. Le procédé de la revendication 4, comprenant en outre:
l'application d'une couche de matériau diélectrique (19) dans la traversée d'interconnexion (6) avant que la métallisation (7) soit appliquée,
la gravure anisotrope du matériau diélectrique jusqu'à ce qu'une aire de contact (20) qui est prévue pour une connexion électrique de la métallisation (7) avec le plan de métal (3) soit découverte et une entretoise de paroi latérale (9) soit formée, et
l'application de la métallisation (7), l'entretoise (9) isolant la métallisation (7) du matériau semiconducteur du substrat (1).
